# EUROPEAN PATENT APPLICATION

(11) **EP 4 582 868 A1**
(43) Date of publication of application: **09.07.2025**
(21) Application number: 24219668.1
(22) Date of filing: 13.12.2024
(51) Int. Cl.: G03F 1/62, B82Y 40/00

(54) **PELLICLE FOR EXTREME ULTRAVIOLET LITHOGRAPHY BASED ON METAL CARBIDE NANOTUBES AND METHOD FOR MANUFACTURING THE SAME**

(30) Priority: 02.01.2024 KR 20240000149
(71) Applicant: Korea Electronics Technology Institute, Bundang-gu, Seongnam-si Gyeonggi-do 13509 (KR)
(72) Inventor: KIM, Hyeong Keun, 16898 Yongin-si, Gyeonggi-do (KR); KIM, Seul Gi, 16902 Yongin-si, Gyeonggi-do (KR)
(74) Representative: Isarpatent

(57) **Abstract**

A pellicle for extreme ultraviolet (EUV) lithography based on metal carbide nanotubes having excellent optical properties, such as EUV transmittance, as well as chemical durability required in the EUV lithography environment is provided. The pellicle includes a frame having an opening formed in a central portion thereof, and a porous pellicle layer supported by the frame, covering the opening, and formed with a mesh structure based on metal carbide nanotubes. A method for manufacturing the pellicle is also provided.

## Description

### TECHNICAL FIELD

The present disclosure relates to extreme ultraviolet (EUV) lithography technology, and more particularly, to a porous pellicle for EUV lithography based on metal carbide nanotubes installed in a photomask used in a lithography process using EUV, and a method for manufacturing the same.

### BACKGROUND

Extreme ultraviolet (EUV) lithography technology using a wavelength of 13.5 nm or less is used in exposure and patterning processes to improve the integration of semiconductor devices and circuits. In these days, continuous research and development is being conducted on key materials and technologies to improve the performance and efficiency of the EUV lithography process.

A pellicle for EUV lithography is a component composed of a thin pellicle layer and a frame to physically prevent contaminants generated during the EUV lithography process from adhering to a photomask. The pellicle is considered as an essential component for improving the yield of wafers and the productivity of the lithography process.

However, the conditions required for the pellicle layer of the pellicle are a EUV transmittance of 90% or more and a free-standing thin film with a thickness of several tens of nm and a size of 110×144 mm to achieve such transmittance. The pellicle layer is an integration of advanced thin film technologies that require mechanical stability not to be damaged by a horizontal acceleration of 20 g inside a EUV exposure machine and chemical stability to ensure a lifetime level of exposing 10,000 wafers in a thermal load and hydrogen radical environment caused by EUV output of 250 W or more. Because of these requirements, extreme material and process technologies are needed to manufacture the pellicle.

Currently, candidate materials proposed as a material of a core layer for the pellicle layer include thermally/chemically stable graphene, graphite, BCN, Si-BN, MoSi₂, SiC, ZrSi₂, Mo₂C, carbon nanotubes, etc. Materials proposed as a protective layer, a buffer layer, or a heat dissipation layer formed on the core layer include SiN, Ru, etc.

It is known that in order for each of such materials to be commercialized in the pellicle layer, further improvements in nanometer-level thickness implementation technology, crystallization technology, thickness uniformity control technology, large-area synthesis technology, and defect control technology should be made. The technology that can implement the pellicle layer with good characteristics through as simple a process as possible is more easily applicable to mass production, so it has high technological value.

Currently, a method for forming a plurality of pinholes in the pellicle layer is being studied to improve the transmittance of the pellicle for EUV lithography. The pinhole formation process is an additional process that is performed after the core layer of the pellicle is synthesized in a thin film form, and is a process of irregularly forming a plurality of pinholes in the core layer. Since this pinhole formation process is performed as a high-cost process such as a lithography process using an electron beam, it may reduce the cost-efficiency at the time of mass production. Therefore, a method for manufacturing a porous pellicle in an easier way and material technology for the same are required.

Meanwhile, a pellicle using a mesh structure of carbon nanotube (CNT) as a porous pellicle layer has been proposed and studied. This CNT pellicle has high mechanical strength while having a EUV transmittance exceeding 90%, so it is being studied as a promising material and structure that will lead the future pellicle market for EUV lithography.

However, the CNT pellicle has the disadvantage that the CNT is easily etched in a EUV scanner environment. This requires the formation of an additional capping layer to protect the CNT mesh structure. Various materials and processes are being studied for the CNT pellicle with the capping layer, but materials and processes that can be mass-produced have not yet been proposed.

### SUMMARY

Accordingly, the present disclosure is intended to provide a pellicle for extreme ultraviolet lithography based on metal carbide nanotubes having excellent optical properties, such as extreme ultraviolet transmittance, as well as chemical durability required in an extreme ultraviolet lithography environment, and a method for manufacturing the same.

In addition, the present disclosure is intended to provide a pellicle for extreme ultraviolet lithography based on metal carbide nanotubes that can be manufactured by an easy manufacturing process, and a method for manufacturing the same.

According to an embodiment of the present disclosure, a method for manufacturing a porous pellicle layer for extreme ultraviolet (EUV) lithography may include producing a sacrificial template with a mesh structure based on nanowires; depositing a metal carbide precursor on a surface of the nanowires forming the sacrificial template; forming a metal carbide by heat-treating the metal carbide precursor; and obtaining the porous pellicle layer composed of the remaining metal carbide by selectively removing the nanowires forming the sacrificial template.

In the obtained porous pellicle layer, the remaining metal carbide may be formed as metal carbide nanotubes corresponding to a shape of the nanowires, and the metal carbide nanotubes form the mesh structure.

The porous pellicle layer may include metal carbide nanotubes having a collapsed form by heat treatment.

The nanowires may be formed of a material capable of being selectively removed with respect to the metal carbide precursor or the metal carbide.

The nanowires may include at least one of carbon nanotubes, semiconductor nanowires, conductor nanowires, and insulator nanowires.

The metal carbide precursor may include at least one of a metal, a metal oxide, a compound or mixture of the metal or metal oxide.

The metal may include at least one of molybdenum (Mo), niobium (Nb), zirconium (Zr), ruthenium (Ru), yttrium (Y), and aluminum (Al).

The metal oxide may include at least one of molybdenum oxide (MoOₓ, 1≤x≤5), niobium oxide (NbOₓ, 1≤x≤3), zirconium oxide (ZrOₓ, 0.25≤x≤2), ruthenium oxide (RuOₓ, 2≤x≤4), yttrium oxide (YOₓ, 1≤x≤3), and aluminum oxide (AlₓO_{y}).

The metal carbide precursor may be deposited using atomic layer deposition (ALD) or chemical vapor deposition (CVD).

Depositing the metal carbide precursor may include forming a first metal carbide precursor on the surface of the nanowires by physical vapor deposition (PVD), and forming a second metal carbide precursor on a surface of the first metal carbide precursor by atomic layer deposition (ALD) or chemical vapor deposition (CVD).

The metal carbide may include at least one of molybdenum carbide, niobium carbide, zirconium carbide, ruthenium carbide, yttrium carbide, and aluminum carbide.

In case that a material of the metal carbide nanotube is molybdenum carbide, the porous pellicle layer may have a EUV transmittance of 96% or more at a thickness of 20 nm or less.

When forming the metal carbide, the metal carbide precursor may be heat-treated at 500°C to 1300°C with a reaction gas containing carbon atoms.

The reaction gas may be a gas containing a hydrocarbon, which includes at least one of methane, ethane, and propane.

When obtaining the porous pellicle layer, the nanowires may be selectively removed by plasma etching.

When obtaining the porous pellicle layer, byproduct generated in a process of forming the metal carbide precursor into the metal carbide may be removed by the plasma etching.

According to another embodiment of the present disclosure, a method for manufacturing a porous pellicle layer for extreme ultraviolet (EUV) lithography may include producing a sacrificial template with a mesh structure based on nanowires; depositing a metal carbide precursor on a surface of the nanowires forming the sacrificial template; selectively removing the nanowires forming the sacrificial template, leaving the metal carbide precursor; and forming a metal carbide by heat-treating the metal carbide precursor, thereby obtaining the porous pellicle layer composed of the metal carbide.

The metal carbide precursor remaining after the nanowires are selectively removed may be formed as metal carbide precursor nanotubes corresponding to a shape of the nanowires, and the metal carbide precursor nanotubes form the mesh structure.

In the obtained porous pellicle layer, the metal carbide precursor nanotubes may be formed into metal carbide nanotubes through heat-treatment, and the metal carbide nanotubes form the mesh structure.

The nanowires may be selectively removed by using at least one of plasma, ozone (O₃), chlorine (Cl₂), chloride, and fluoride.

According to yet another embodiment of the present disclosure, a pellicle for extreme ultraviolet (EUV) lithography may include a frame having an opening formed in a central portion thereof, and a porous pellicle layer supported by the frame, covering the opening, and formed with a mesh structure based on metal carbide nanotubes.

According to the present disclosure, the porous pellicle layer is formed with a porous structure based on the metal carbide nanotubes, thereby providing excellent optical properties such as EUV transmittance and chemical durability required in the EUV lithography environment.

According to the present disclosure, the porous pellicle layer is manufactured by utilizing the sacrificial template formed with the mesh structure based on the nanowires, so that it is possible to easily manufacture the porous pellicle layer having a porous structure based on the metal carbide nanotubes. That is, although it is difficult to implement a technique for directly forming metal carbide on the surface of nanowires, a metal oxide that is easy to deposit is first deposited on the surface of the nanowires, and then the metal oxide is reacted with a gas containing carbon at a high temperature to simultaneously realize reduction and carbonization of the metal oxide, thereby forming the metal carbide more easily. Thereafter, by removing the sacrificial template by plasma etching or the like, the remaining metal carbide is formed as metal carbide nanotubes corresponding to the shape of the sacrificial template, and thus the porous pellicle layer having the mesh structure is obtained.

In the manufacturing process of the porous pellicle layer according to the present disclosure, removing the sacrificial template can further improve the EUV transmittance of the finally obtained porous pellicle layer than maintaining the sacrificial template.

In addition, since the finally obtained porous pellicle layer according to the present disclosure does not have the sacrificial template that may be vulnerable to hydrogen plasma, it can provide good chemical durability required in the EUV lithography environment.

### BRIEF DESCRIPTION OF THE DRAWINGS

FIG. 1 is a plan view showing a pellicle for EUV lithography based on a metal carbide nanotube according to the present disclosure.
FIG. 2 is an enlarged view of portion A of FIG. 1.
FIG. 3 is a cross-sectional view showing the metal carbide nanotube of FIG. 2.
FIG. 4 is a cross-sectional view taken along line 4-4 of FIG. 1.
FIG. 5 is an enlarged view of portion B of FIG. 4.
FIG. 6 is a flowchart showing a first example of a method for manufacturing a pellicle layer for EUV lithography based on a metal carbide nanotube according to the present disclosure.
FIGS. 7 to 12 are diagrams showing respective steps of the manufacturing method according to the first example of FIG. 6, wherein:

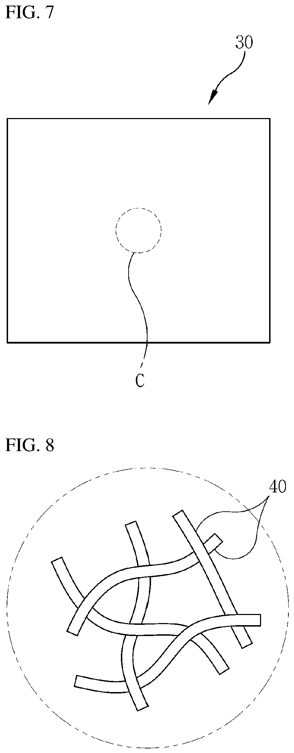

   FIG. 7 is a plan view showing a sacrificial template,
   FIG. 8 is an enlarged view of portion C of FIG. 7,

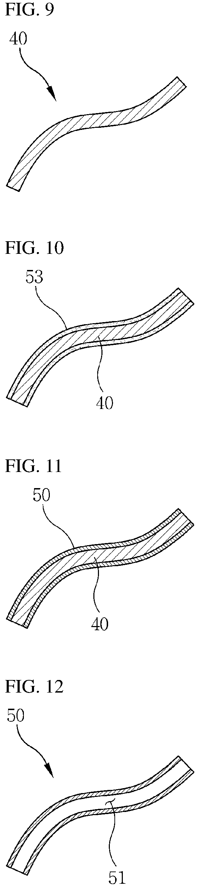

   FIG. 9 is a cross-sectional view showing a nanowire forming the sacrificial template of FIG. 8,
   FIG. 10 is a cross-sectional view showing a state in which a metal carbide precursor is deposited on a surface of the nanowire forming the sacrificial template,
   FIG. 11 is a cross-sectional view showing a state in which a metal carbide is formed by heat-treating the metal carbide precursor, and
   FIG. 12 is a cross-sectional view showing a metal carbide nanotube remaining after the sacrificial template is selectively removed.

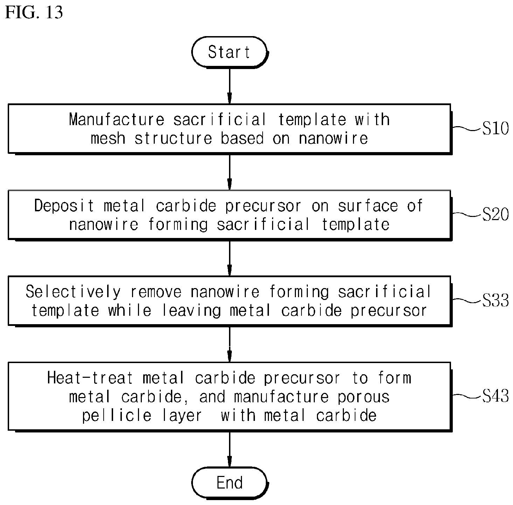

   FIG. 13 is a flowchart showing a second example of a method for manufacturing a pellicle layer for EUV lithography based on a metal carbide nanotube according to the present disclosure.

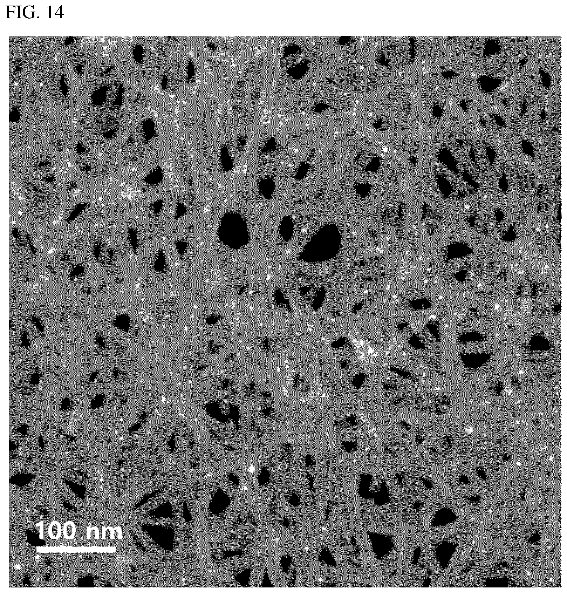

   FIG. 14 is a transmission electron microscope (TEM) photograph showing a state in which a metal carbide precursor is deposited on a surface of a sacrificial template manufactured by the manufacturing method of FIG. 13.

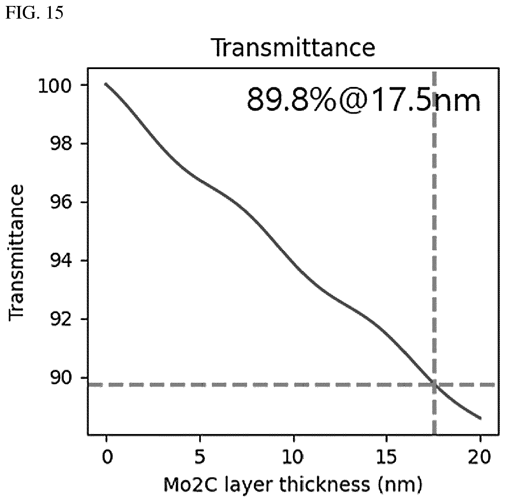

   FIG. 15 is a graph showing the EUV transmittance of a porous pellicle layer according to a first comparative example.

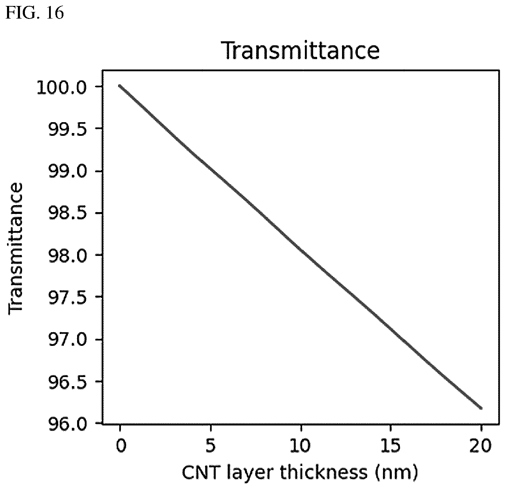

   FIG. 16 is a graph showing the EUV transmittance of a porous pellicle layer according to a second comparative example.

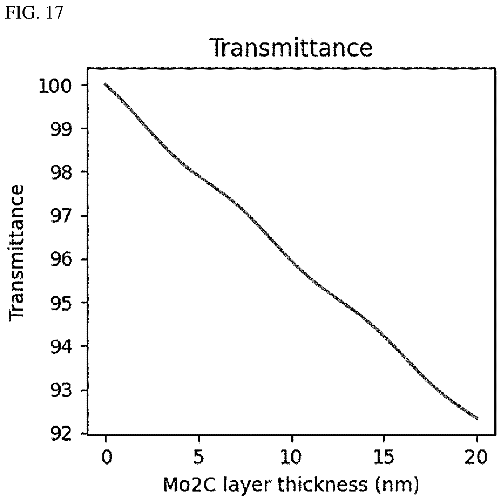

   FIG. 17 is a graph showing the EUV transmittance of a porous pellicle layer according to a third comparative example.

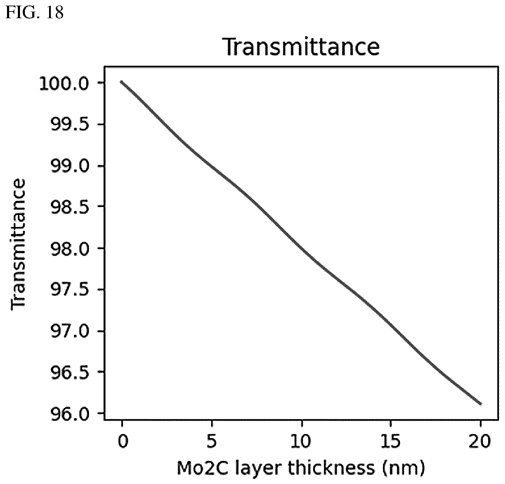

   FIG. 18 is a graph showing the EUV transmittance of a porous pellicle layer according to an embodiment of the present disclosure.

### DETAILED DESCRIPTION

Now, embodiments of the present disclosure will be described in detail with reference to the accompanying drawings. However, in the following description and the accompanying drawings, well known techniques may not be described or illustrated in detail to avoid obscuring the subject matter of the present disclosure. Through the drawings, the same or similar reference numerals denote corresponding features consistently.

The terms and words used in the following description, drawings and claims are not limited to the bibliographical meanings thereof and are merely used by the inventor to enable a clear and consistent understanding of the disclosure. Thus, it will be apparent to those skilled in the art that the following description about various embodiments of the present disclosure is provided for illustration purpose only and not for the purpose of limiting the disclosure as defined by the appended claims and their equivalents.

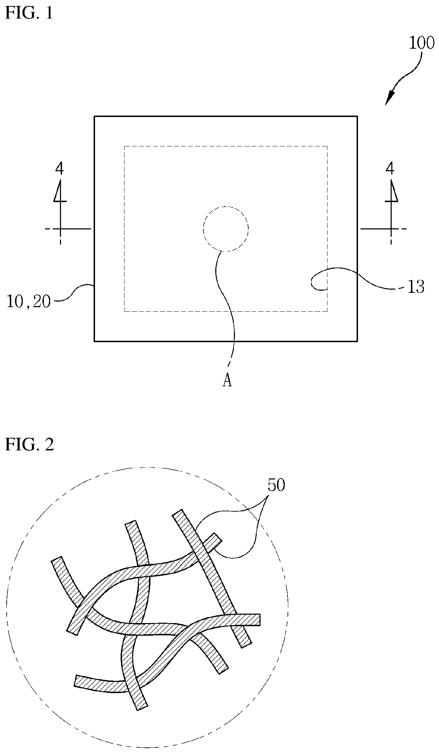

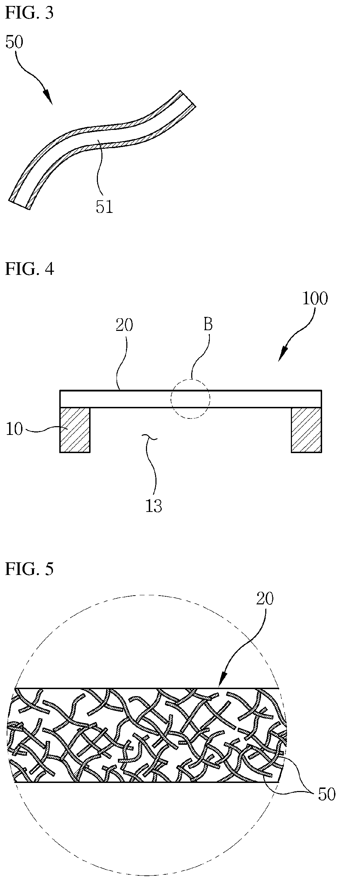

FIG. 1 is a plan view showing a pellicle for EUV lithography based on a metal carbide nanotube according to the present disclosure. FIG. 2 is an enlarged view of portion A of FIG. 1. FIG. 3 is a cross-sectional view showing the metal carbide nanotube of FIG. 2. FIG. 4 is a cross-sectional view taken along line 4-4 of FIG. 1. FIG. 5 is an enlarged view of portion B of FIG. 4.

Referring to FIGS. 1 to 5, a pellicle 100 for extreme ultraviolet (EUV) lithography according to the present disclosure (hereinafter referred to as "pellicle") includes a porous pellicle layer 20 having a free-standing structure supported by a frame 10. The frame 10 has an opening 13 formed in its central portion. The porous pellicle layer 20 is supported by the frame 10 while covering the opening 13, and is formed with a mesh structure based on metal carbide nanotubes 50.

The pellicle 100 is a consumable material used to protect a photomask from foreign substances during a lithography process of the semiconductor or display manufacturing process. That is, the pellicle 100 is a thin film that is placed as a cover on the photomask. During exposure, the light transferred to the wafer is focused on the photomask. Therefore, even if there are foreign substances on the pellicle 100, the use of the pellicle 100 that is a certain distance away from the photomask can reduce the formation of defective patterns by not affecting the size of a pattern to be created.

As such, the pellicle 100 can protect the photomask from foreign substances during the lithography process while minimizing defective patterns, thereby increasing the yield of the semiconductor or display manufacturing process. In addition, the use of the pellicle 100 can extend the life of the photomask.

The porous pellicle layer 20 according to the present disclosure is formed in a porous structure based on the metal carbide nanotubes 50, thereby providing excellent optical properties (such as EUV transmittance of 90% or more) and chemical durability, which are required in the EUV lithography environment.

Now, the pellicle 100 according to the present disclosure will be described in detail. As described above, the pellicle 100 includes the frame 10 and the porous pellicle layer 20.

The frame 10 supports the porous pellicle layer 20 and facilitates handling and transport of the porous pellicle layer 20 during and after the process of manufacturing the pellicle 100 for EUV lithography. The frame 10 may be formed of a material that can be etched, such as silicon. For example, the material of the frame 10 may be, but is not limited to, silicon, silicon oxide, silicon nitride, metal oxide, metal nitride, graphite, amorphous carbon, etc., and a structure in which the above materials are stacked may also be possible. Here, metal may be, but is not limited to, Cr, Al, Zr, Ti, Ta, Nb, Ni, etc.

The opening 13 formed in the central portion of the frame 10 may be formed using a micro-processing technology such as micro-electro mechanical systems (MEMS). That is, the central portion of the frame 10 is removed through the micro-processing technology to form the opening 13. The porous pellicle layer 20 is exposed through the opening 13.

The porous pellicle layer 20 is supported by the frame 10. The porous pellicle layer 20 is formed in a mesh structure based on the metal carbide nanotubes 50. For example, the material of the metal carbide nanotubes 50 includes at least one of molybdenum carbide, niobium carbide, zirconium carbide, ruthenium carbide, yttrium carbide, and aluminum carbide. A portion of porous pellicle layer 20 exposed to the opening 13 may occupy 70% or more of the total area.

The porous pellicle layer 20 may be manufactured as a mesh structure based on nanowires, using a sacrificial template. Most of the metal carbide nanotubes 50 in the porous pellicle layer 20 are formed in a mesh structure. The porous pellicle layer 20 may include in part the metal carbide nanotubes 50 that have a collapsed form due to heat treatment. A method for manufacturing the porous pellicle layer 20 using the sacrificial template will be described later.

The shape of the porous pellicle layer 20 may depend on the shape of the frame 10. For example, if the frame 10 has a circular or square ring shape, the porous pellicle layer 20 may also have a circular or square plate shape corresponding to the shape of the frame 10.

The porous pellicle layer 20 is formed in a mesh structure based on the metal carbide nanotubes 50, so that can exhibit excellent EUV transmittance of 90% or more. That is, since the metal carbide nanotube 50 has a nanotube shape with a hollow space 51 therein, it has a relatively high EUV transmittance compared to a nanowire with a filled interior. In addition, since the porous pellicle layer 20 is formed as a membrane in which the metal carbide nanotubes 50 are connected in a mesh structure, it has a relatively high EUV transmittance due to pores formed between the metal carbide nanotubes 50 compared to a metal carbide layer having the same thickness as the porous pellicle layer 20. For example, in the case where the material of the metal carbide nanotubes 50 is molybdenum carbide, the EUV transmittance is 96% or more at the thickness of the porous pellicle layer 20 of 20 nm or less.

In addition, since the metal carbide nanotubes 50 forming the porous pellicle layer 20 have corrosion resistance to hydrogen radicals, they can provide good chemical durability required in the EUV lithography environment.

As will be described later, the porous pellicle layer 20 according to the present disclosure can be manufactured based on a sacrificial template, so that the porous pellicle layer 20 can be easily manufactured compared to the existing pinhole forming process.

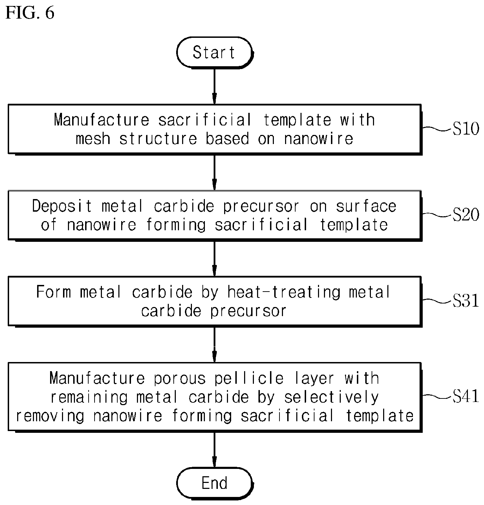

Hereinafter, a method for manufacturing the porous pellicle layer 20 according to the present disclosure will be described with reference to FIGS. 6 to 13.

### [Manufacturing method of the porous pellicle layer according to first example]

FIG. 6 is a flowchart showing a first example of a method for manufacturing a pellicle layer for EUV lithography based on a metal carbide nanotube according to the present disclosure.

Referring to FIG. 6, in step S10, a sacrificial template is produced with a mesh structure based on nanowires. Next, in step S20, a precursor of metal carbide (hereinafter referred to as 'metal carbide precursor') is deposited on the surface of the nanowires forming the sacrificial template. Then, in step S31, the metal carbide precursor is heat-treated to form a metal carbide. Then, in step S41, the nanowire forming the sacrificial template is selectively removed to obtain a porous pellicle layer composed of the remaining metal carbide.

Hereinafter, this manufacturing method according to the first example will be described in detail with reference to FIGS. 7 to 12. FIGS. 7 to 12 are diagrams showing respective steps of the manufacturing method according to the first example of FIG. 6.

As shown in FIGS. 7 to 9, in step S10, the sacrificial template 30 is manufactured in a mesh structure based on the nanowires 40. The sacrificial template 30 may have a size corresponding to the size of the porous pellicle layer to be manufactured.

The nanowire 40 is formed of a material that can be selectively removed with respect to the metal carbide precursor 53 or the metal carbide. The nanowire 40 includes at least one of a carbon nanotube, a semiconductor nanowire, a conductor nanowire, and an insulator nanowire.

The nanowire 40 may have a rod shape with the interior filled, or a nanotube shape with a hollow formed inside. FIG. 9 exemplarily shows a rod-shaped nanowire 40 with its interior filled.

The semiconductor nanowire includes a nanowire based on a semiconductor material such as silicon.

The conductor nanowire includes a nanowire based on at least one conductor among Mo, Zr, Ru, Nb, Mo2C, MoC, ZrC, and NbC.

The insulator nanowire includes a nanowire based on at least one insulator among SiO₂, TiO₂, BN, SiC, ZrO₂, MoO₃, Y₂O₃, and MgO.

The nanowires 40 may be formed using the above-mentioned materials alone, as a compound, or as a mixture. In addition, the sacrificial template 30 may be formed as a mesh structure of a single type of the nanowires 40 or as a mesh structure of two or more types of the nanowires 40.

The sacrificial template 30 may be manufactured by weaving the nanowires 40 or by electrospinning the nanowires 40 into a sheet form. The sacrificial template 30 may be implemented as a sheet having a large number of pores, for example, in the form of a mesh net or nonwoven fabric.

Next, as shown in FIG. 10, in step S20, the metal carbide precursor 53 is deposited on the surface of the nanowires 40 forming the sacrificial template 30.

The metal carbide precursor 53 may be formed by at least one process among atomic layer deposition (ALD), chemical vapor deposition (CVD), and physical vapor deposition (PVD). For example, the metal carbide precursor 53 may be formed directly on the surface of the nanowire 40 by ALD or CVD. Alternatively, after the first metal carbide precursor 53 is formed on the surface of the nanowire 40 by PVD, the second metal carbide precursor may be formed on the surface of the first metal carbide precursor by ALD or CVD. In this case, the first metal carbide precursor is used as a buffer layer between the nanowire 40 and the second metal carbide precursor. The first metal carbide precursor may be formed to a thickness of 1 to 5 nm.

The metal carbide precursor 53 (i.e., the precursor of metal carbide) includes at least one of a metal, a metal oxide, a compound or mixture of the metal or metal oxide.

Herein, the metal includes at least one of molybdenum (Mo), niobium (Nb), zirconium (Zr), ruthenium (Ru), yttrium (Y), and aluminum (Al).

The metal oxide includes at least one of molybdenum oxide (MoOₓ, 1≤x≤5), niobium oxide (NbOₓ, 1≤x≤3), zirconium oxide (ZrOₓ, 0.25≤x≤2), ruthenium oxide (RuOₓ, 2≤x≤4), yttrium oxide (YOₓ, 1≤x≤3), and aluminum oxide (AlₓO_{y}).

Next, as shown in FIG. 11, in step S31, the metal carbide precursor 53 is heat-treated to form a metal carbide. Here, the heat treatment is performed at 500°C to 1300°C with a reaction gas containing carbon atoms. During the heat treatment, a reaction between the metal contained in the metal carbide precursor 53 and the reaction gas is induced, and the metal carbide precursor 53 formed on the surface of the nanowire 40 is converted into a metal carbide.

If a metal oxide is used as the metal carbide precursor 53, the oxygen in the metal oxide is removed by the heat treatment. Since the nanowires 40 constituting the sacrificial template 30 are protected by the metal carbide precursor 53, it remains as is without chemically reacting with the material constituting the metal carbide precursor 53 and the reaction gas during the heat treatment. Of course, the material located on the surface of the nanowire 40 forming an interface with the metal carbide precursor 53 may react with the metal carbide precursor 53 or the reaction gas during the heat treatment to form a compound.

The reaction gas may be a gas containing a hydrocarbon, which includes at least one of methane, ethane, and propane.

The metal carbide is based on the material of the metal carbide precursor 53. For example, the metal carbide may include at least one of molybdenum carbide, niobium carbide, zirconium carbide, ruthenium carbide, yttrium carbide, and aluminum carbide.

The reason why the metal carbide is formed on the surface of the nanowire 40 using the metal carbide precursor 53 in the present disclosure is that it is not easy to directly form the metal carbide on the surface of the nanowire 40. On the other hand, by forming the metal or metal oxide that is easy to be deposited on the surface of the nanowire 40 and then reacting it with the reaction gas containing carbon at a high temperature to simultaneously perform reduction and carbonization of the oxide, the metal carbide can be easily formed on the surface of the nanowire 40.

As shown in FIG. 12, in step S41, the nanowires 40 forming the sacrificial template 30 are selectively removed, and resultantly the porous pellicle layer is manufactured with the remaining metal carbide. That is, in the porous pellicle layer, the remaining metal carbide is formed into the metal carbide nanotube 50 corresponding to the outer shape of the nanowire 40. As a result, the metal carbide nanotubes 50 form a mesh structure corresponding to the sacrificial template 30. The porous pellicle layer may include the metal carbide nanotubes 50 that have a collapsed shape due to heat treatment.

The nanowire 40 is selectively removed with respect to the metal carbide by plasma etching. Byproduct generated in the process of forming the metal carbide precursor 53 into the metal carbide is also removed by plasma etching. Here, the byproduct may be amorphous carbon, graphene, or graphite.

As a gas used for plasma etching, a gas having a high etching selectivity with respect to the sacrificial template 30 and the metal carbide may be used. For example, this gas used for plasma etching may include at least one of hydrogen and oxygen.

### [Manufacturing method of the porous pellicle layer according to second example]

In the manufacturing method according to the first example, the step of removing the sacrificial template is performed after the heat treatment. However, the method is not limited to this example. Alternatively, as shown in FIG. 13, the heat treatment may be performed after the removal of the sacrificial template. FIG. 13 is a flowchart showing a second example of a method for manufacturing a pellicle layer for EUV lithography based on a metal carbide nanotube according to the present disclosure.

First, in step S10, the sacrificial template is produced with a mesh structure based on the nanowires. Next, in step S20, the metal carbide precursor is deposited on the surface of the nanowires forming the sacrificial template. Then, in step S33, the nanowires forming the sacrificial template are selectively removed, leaving the metal carbide precursor. Then, in step S43, the metal carbide precursor is heat-treated to form the metal carbide, and the porous pellicle layer is obtained with the metal carbide.

In the manufacturing method according to the second example, steps S10 and S20 are performed in the same manner as the manufacturing method according to the first example, so their descriptions are omitted. The details of steps S33 and S43 are as follows.

In step S33, leaving the metal carbide precursor, the nanowires forming the sacrificial template are selectively removed. When the nanowires are selectively removed, a plasma process may be used. Alternatively, since the nanowire removal process is performed before the heat treatment process, the nanowires may be removed by dry etching using at least one of ozone (O₃), chlorine (Cl₂), chloride, and fluoride in addition to plasma.

Then, in step S43, the metal carbide precursor is heat-treated to form the metal carbide, and therefore the porous pellicle layer having the metal carbide is obtained.

At this time, the remaining metal carbide precursor with the nanowire removed is formed into a metal carbide precursor nanotube corresponding to the outer shape of the nanowire. The metal carbide precursor nanotube is formed into a metal carbide nanotube by heat treatment. Such metal carbide nanotubes form a mesh structure, so that the porous pellicle layer is manufactured. That is, in the porous pellicle layer, the remaining metal carbide precursor nanotubes are formed into the metal carbide nanotubes each corresponding to the shape of the nanowire. As a result, the metal carbide nanotubes form a mesh structure corresponding to the sacrificial template. The porous pellicle layer may include the metal carbide nanotubes having a form collapsed by heat treatment.

Using the manufacturing method according to the second example, the porous pellicle layer may be manufactured as follows.

First, by depositing aluminum oxide on a CNT membrane which is one of sacrificial templates, a porous membrane in which CNTs are coated with the aluminum oxide can be obtained as shown in FIG. 14. FIG. 14 is a transmission electron microscope (TEM) photograph showing a state in which a metal carbide precursor is deposited on a surface of a sacrificial template manufactured by the manufacturing method of FIG. 13.

Referring to FIG. 14, all of the aluminum oxides formed on the surfaces of the CNTs forming the CNT membrane can be densely connected.

Next, when the CNT membrane coated with the aluminum oxide is etched in an etching environment such as hydrogen plasma and oxygen plasma, the CNTs are etched and the aluminum oxide is not etched. That is, a porous membrane composed of aluminum oxide nanotubes can be manufactured by selectively etching the CNTs with plasma. Thereafter, by heat-treating the aluminum oxide nanotube-based porous membrane at a high temperature of 500°C to 1,300°C to convert the aluminum oxide nanotubes into aluminum carbide nanotubes, an aluminum carbide nanotube-based porous membrane in which the aluminum carbide nanotubes are connected in a mesh structure, i.e., a pellicle layer, can be manufactured.

As such, according to the manufacturing methods according to the first and second examples, the porous pellicle layer in which the metal carbide nanotubes are connected in a mesh structure can be manufactured more easily using the sacrificial template.

### [Comparative Examples and Embodiment]

In order to confirm the EUV transmittance of the pellicle layer manufactured by the manufacturing method of the present disclosure in a EUV output environment of 350 W or more, simulations were performed on the pellicle layers according to first to third comparative examples and an embodiment as shown in FIGS. 15 to 18.

In the first comparative example, a Mo₂C thin layer was used as the pellicle layer.

In the second comparative example, a CNT membrane without a capping layer was used as the porous pellicle layer. In the CNT membrane, CNTs are connected in a mesh structure.

In the third comparative example, the porous pellicle layer is based on the CNT membrane according to the second comparative example and has a capping layer of Mo₂C. The thickness of the capping layer is 3 nm.

The porous pellicle layer according to an embodiment of the disclosure is based on the CNT membrane according to the third comparative example, but CNTs are removed and Mo₂C nanotubes are connected in a mesh structure. That is, the porous pellicle layer according to the embodiment is a membrane in which Mo₂C nanotubes are connected in a mesh structure.

FIG. 15 is a graph showing the EUV transmittance of a pellicle layer according to a first comparative example.

Referring to FIG. 15, it can be seen that the pellicle layer according to the first comparative example has a EUV transmittance of approximately 90% at a thickness of 17.5 nm.

FIG. 16 is a graph showing the EUV transmittance of a porous pellicle layer according to a second comparative example.

Referring to FIG. 16, it can be seen that the porous pellicle layer according to the second comparative example has a EUV transmittance of approximately 96.2% at a thickness of 20 nm.

FIG. 17 is a graph showing the EUV transmittance of a porous pellicle layer according to a third comparative example.

Referring to FIG. 17, it can be seen that the porous pellicle layer according to the third comparative example has a EUV transmittance of approximately 92.3% at a CNT membrane thickness of 20 nm when Mo₂C was coated on the CNT membrane to a thickness of 3 nm.

FIG. 18 is a graph showing the EUV transmittance of a porous pellicle layer according to an embodiment of the present disclosure.

Referring to FIG. 18, it can be seen that the porous pellicle layer according to the embodiment has a EUV transmittance of approximately 96.2% at a thickness of 20 nm. When the target of the EUV transmittance is 90% or more, the porous pellicle layer according to the embodiment can be formed to have a thickness greater than 20 nm, for example, to have a thickness of 40 nm or more.

It can be seen that the porous pellicle layer formed of a mesh structure of metal carbide nanotubes with the sacrificial template removed, as in the embodiment, exhibits a high EUV transmittance equivalent to that of the porous pellicle layer formed of a CNT membrane without a capping layer, as in the second comparative example.

Meanwhile, the porous pellicle layer according to the second comparative example has a disadvantage of being vulnerable to hydrogen radicals because it is composed of a CNT membrane without a capping layer. On the other hand, the porous pellicle layer according to the embodiment has corrosion resistance against hydrogen radicals because it is composed of Mo₂C nanotubes, and thus provides good chemical durability required in the EUV lithography environment.

Comparing the embodiment and the third comparative example, the porous pellicle according to the third comparative example includes a CNT membrane and Mo₂C nanotubes, whereas the porous pellicle according to the embodiment has a structure in which the CNT membrane is removed from the porous pellicle according to the third comparative example. It can be seen that by removing the CNT membrane as in the embodiment, the porous pellicle according to the embodiment exhibits relatively higher EUV transmittance than that of the third comparative example.

As described above, the present disclosure can manufacture the porous pellicle layer that is more chemically stable by removing the sacrificial template and impurities that are vulnerable to a hydrogen plasma environment, which is the EUV lithography environment, through plasma etching. In addition, the present disclosure can improve the EUV transmittance of the porous pellicle layer by removing the sacrificial template after forming the metal carbide nanotube or the metal carbide precursor using the sacrificial template, compared to the case where the sacrificial template is maintained.

Therefore, the porous pellicle layer according to the embodiment of the present disclosure can provide a high EUV transmittance of 90% or more and chemical durability required in the EUV lithography environment.

While the present disclosure has been particularly shown and described with reference to an exemplary embodiment thereof, it will be understood by those skilled in the art that various changes in form and details may be made therein without departing from the scope of the present disclosure as defined by the appended claims.

## Claims

1. A method for manufacturing a porous pellicle layer for extreme ultraviolet (EUV) lithography, the method comprising:
producing a sacrificial template with a mesh structure based on nanowires;
depositing a metal carbide precursor on a surface of the nanowires forming the sacrificial template;
forming a metal carbide by heat-treating the metal carbide precursor; and
obtaining the porous pellicle layer composed of the remaining metal carbide by selectively removing the nanowires forming the sacrificial template.

2. The method of claim 1, wherein in the obtained porous pellicle layer, the remaining metal carbide is formed as metal carbide nanotubes corresponding to a shape of the nanowires, and the metal carbide nanotubes form the mesh structure.

3. The method of claim 2, wherein the porous pellicle layer includes metal carbide nanotubes having a collapsed form by heat treatment.

4. The method of claim 2, wherein the nanowires are formed of a material capable of being selectively removed with respect to the metal carbide precursor or the metal carbide.

5. The method of claim 3, wherein the nanowires include at least one of carbon nanotubes, semiconductor nanowires, conductor nanowires, and insulator nanowires.

6. The method of claim 2, wherein the metal carbide precursor includes at least one of a metal, a metal oxide, a compound or mixture of the metal or metal oxide,
wherein the metal includes at least one of molybdenum (Mo), niobium (Nb), zirconium (Zr), ruthenium (Ru), yttrium (Y), and aluminum (Al), and
wherein the metal oxide includes at least one of molybdenum oxide (MoOₓ, 1≤x≤5), niobium oxide (NbOₓ, 1≤x≤3), zirconium oxide (ZrOₓ, 0.25≤x≤2), ruthenium oxide (RuOₓ, 2≤x≤4), yttrium oxide (YOₓ, 1≤x≤3), and aluminum oxide (AlₓO_{y}).

7. The method of claim 6, wherein the metal carbide precursor is deposited using atomic layer deposition (ALD) or chemical vapor deposition (CVD).

8. The method of claim 6, wherein depositing the metal carbide precursor includes:
forming a first metal carbide precursor on the surface of the nanowires by physical vapor deposition (PVD); and
forming a second metal carbide precursor on a surface of the first metal carbide precursor by atomic layer deposition (ALD) or chemical vapor deposition (CVD).

9. The method of claim 6, wherein the metal carbide includes at least one of molybdenum carbide, niobium carbide, zirconium carbide, ruthenium carbide, yttrium carbide, and aluminum carbide.

10. The method of claim 6, wherein in case that a material of the metal carbide nanotube is molybdenum carbide, the porous pellicle layer has a EUV transmittance of 96% or more at a thickness of 20 nm or less.

11. The method of claim 1, wherein when forming the metal carbide, the metal carbide precursor is heat-treated at 500°C to 1300°C with a reaction gas containing carbon atoms.

12. The method of claim 11, wherein the reaction gas is a gas containing a hydrocarbon, which includes at least one of methane, ethane, and propane.

13. The method of claim 1, wherein when obtaining the porous pellicle layer, the nanowires are selectively removed by plasma etching.

14. The method of claim 13, wherein when obtaining the porous pellicle layer, byproduct generated in a process of forming the metal carbide precursor into the metal carbide is removed by the plasma etching.

15. A method for manufacturing a porous pellicle layer for extreme ultraviolet (EUV) lithography, the method comprising:
producing a sacrificial template with a mesh structure based on nanowires;
depositing a metal carbide precursor on a surface of the nanowires forming the sacrificial template;
selectively removing the nanowires forming the sacrificial template, leaving the metal carbide precursor; and
forming a metal carbide by heat-treating the metal carbide precursor, thereby obtaining the porous pellicle layer composed of the metal carbide.

16. The method of claim 15, wherein the metal carbide precursor remaining after the nanowires are selectively removed is formed as metal carbide precursor nanotubes corresponding to a shape of the nanowires, and the metal carbide precursor nanotubes form the mesh structure, and
wherein in the obtained porous pellicle layer, the metal carbide precursor nanotubes are formed into metal carbide nanotubes through heat-treatment, and the metal carbide nanotubes form the mesh structure.

17. The method of claim 15, wherein the nanowires are selectively removed by using at least one of plasma, ozone (O₃), chlorine (Cl₂), chloride, and fluoride.

18. A pellicle for extreme ultraviolet (EUV) lithography, comprising:
a frame having an opening formed in a central portion thereof; and
a porous pellicle layer supported by the frame, covering the opening, and formed with a mesh structure based on metal carbide nanotubes.

19. The pellicle of claim 18, wherein a material of the metal carbide nanotubes includes at least one of molybdenum carbide, niobium carbide, zirconium carbide, ruthenium carbide, yttrium carbide, and aluminum carbide.

20. The pellicle of claim 18, wherein in case that a material of the metal carbide nanotube is molybdenum carbide, the porous pellicle layer has a EUV transmittance of 96% or more at a thickness of 20 nm or less.
